# DEMANDE DE BREVET EUROPEEN

(11) **EP 4 435 835 A1**
(43) Date de publication de la demande: **25.09.2024**
(21) Numéro de dépôt: 24164318.8
(22) Date de dépôt: 18.03.2024
(51) Int. Cl.: H01L 21/48, H01L 21/56, H01L 21/683, H01L 23/31

(54) **PROCÉDÉ DE FABRICATION D'UNE PLURALITÉ DE COMPOSANTS ÉLECTRONIQUES**

(30) Priorité: 22.03.2023 FR 2302713
(71) Demandeur: STMicroelectronics International N.V., 1228 Plan-les-Ouates, Geneva (CH)
(72) Inventeur: ORY, Olivier, 37100 TOURS (FR); DE CRUZ, Michael, 37380 MONNAIE (FR)
(74) Mandataire: Cabinet Beaumont

(57) **Abrégé**

La présente description concerne un procédé de fabrication de premiers composants électroniques (31) comportant chacun un deuxième composant électronique (100), chaque deuxième composant comportant au moins deux métallisations de contact (102), le procédé comportant :
a) former, sur un substrat (11), au moins deux piliers métalliques (21) ;
b) former, sur une partie de la surface de chaque pilier, une métallisation (23) du composant ;
c) recouvrir ladite face du substrat (11), les piliers et les métallisations des premiers composants (31) par une première couche en résine (27) ;
d) retirer le substrat de façon à dévoiler une face des piliers, opposée aux métallisations des composants ;
e) fixer et connecter électriquement les deuxièmes composants, par leurs métallisations, sur la face des piliers opposée aux métallisations des premiers composants ; et
f) dévoiler la face des métallisations des premiers composants opposée aux piliers.

## Description

### Domaine technique

La présente description concerne un procédé de fabrication de composants électronique comportant chacun une puce électronique. Elle vise plus particulièrement un procédé de fabrication de composants électroniques dits à montage en surface (SMD - de l'anglais « Surface Mounted Device »), c'est-à-dire comportant, du côté d'au moins une face, au moins deux métallisations de contact destinées à être brasées à des plages de connexion correspondantes d'un dispositif extérieur, par exemple une carte de circuit imprimé ou un autre composant électronique.

### Technique antérieure

De nombreux procédés de fabrication de composants électroniques à montage en surface ont été proposés. Un mode de réalisation pallie tout ou partie des inconvénients des procédés connus de fabrication de composants électroniques à montage en surface.

### Résumé de l'invention

Un mode de réalisation prévoit un procédé de fabrication d'une pluralité de premiers composants électroniques comportant chacun un deuxième composant électronique, chaque deuxième composant électronique comportant au moins deux métallisations de contact du côté d'une face de connexion du deuxième composant électronique, le procédé comportant les étapes successives suivantes :
a) former, sur une face d'un substrat, pour chaque deuxième composant électronique, au moins deux piliers métalliques destinés à être connectés respectivement auxdites au moins deux métallisations de contact du deuxième composant électronique, lesdits piliers métalliques présentant chacun une surface supérieure à la surface de la métallisation de contact correspondante du deuxième composant électronique ;
b) former, sur une partie seulement de la surface de chaque pilier métallique, une métallisation de contact du composant électronique ;
c) recouvrir ladite face du substrat, les piliers métallique et les métallisations de contact des premiers composants électroniques par une première couche en résine ;
d) retirer le substrat de façon à dévoiler une face des piliers métalliques, opposée aux métallisations de contact des composants électroniques ;
e) fixer et connecter électriquement les deuxièmes composants électroniques, par leurs métallisations de contact, sur la face des piliers métalliques opposée aux métallisations de contact des premiers composants électroniques ;
f) amincir la première couche en résine de façon à dévoiler la face des métallisations de contact des premiers composants électroniques opposée aux piliers métalliques ; et
g) découper la première couche en résine de façon à individualiser les premiers composants électroniques.

Selon un mode de réalisation, les piliers métalliques sont formés par croissance électrolytique.

Selon un mode de réalisation, les métallisations de contact des premiers composants électroniques sont formées par croissance électrolytique.

Selon un mode de réalisation, le procédé comporte, après l'étape e) une étape de recouvrement des deuxièmes composants électroniques, et des métallisations de contact des premiers composants électroniques par une deuxième couche en résine.

Selon un mode de réalisation, lors de la découpe de l'étape g), les flancs des piliers métalliques et des métallisations de contact des premiers composants électroniques sont dévoilés.

Selon un mode de réalisation, les piliers métalliques sont en cuivre, en or, en étain, en argent ou en un alliage de plusieurs de ces matériaux.

Selon un mode de réalisation, les métallisations de contact des premiers composants électroniques sont en cuivre, en or, en étain, en argent ou en un alliage de plusieurs de ces matériaux.

Selon un mode de réalisation, les métallisations de contact des premiers composants électroniques ont une hauteur comprise entre 20 µm et 100 µm.

Selon un mode de réalisation, les métallisations de contact des premiers composants électroniques ont une hauteur supérieure ou égale à 30 µm.

Selon un mode de réalisation, les piliers métalliques ont une hauteur comprise entre 80 µm et 150 µm.

Selon un mode de réalisation, lors de l'étape g), la découpe de la première couche en résine est réalisée de sorte que la première couche en résine subsiste sur des flancs du composant électronique.

Selon un mode de réalisation, lors de l'étape g), la découpe de la première couche en résine est réalisée de sorte que, à l'issue de cette étape, les métallisations de contact des premiers composants électroniques et les piliers métalliques affleurent des flancs du composant électronique.

Selon un mode de réalisation, lors de l'étape g), un premier trait de découpe traversant est réalisé de sorte que les métallisations de contact des premiers composants électroniques et les piliers métalliques affleurent des flancs du composant électronique et un deuxième trait de découpe non traversant, dont la largeur de découpe est supérieure à la largeur de découpe du premier trait de découpe, est réalisé de façon à découvrir une partie de la face des piliers métalliques opposée aux métallisations de contact des premiers composants électroniques.

Selon un mode de réalisation, après l'étape e), la structure est stockée pour être utilisée ultérieurement.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
La figure 1 est une vue en perspective illustrant deux composants électroniques à montage en surface ; et
la figure 2A, la figure 2B, la figure 2C, la figure 2D, la figure 2E, la figure 2F, la figure 2G, la figure 2H, la figure 2I, la figure 2J, la figure 2K, la figure 2L, la figure 2M et la figure 2N sont des vues, en coupe et de dessus, partielles et schématiques, d'étapes successives d'un procédé de fabrication d'un composant électronique à montage en surface selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation de puces semiconductrices des composants électroniques décrits n'a pas été détaillée, les modes de réalisation décrits étant compatibles avec toutes ou la plupart des puces semiconductrices connues ou la réalisation de telles puces étant à la portée de la personne du métier à partir des indications de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

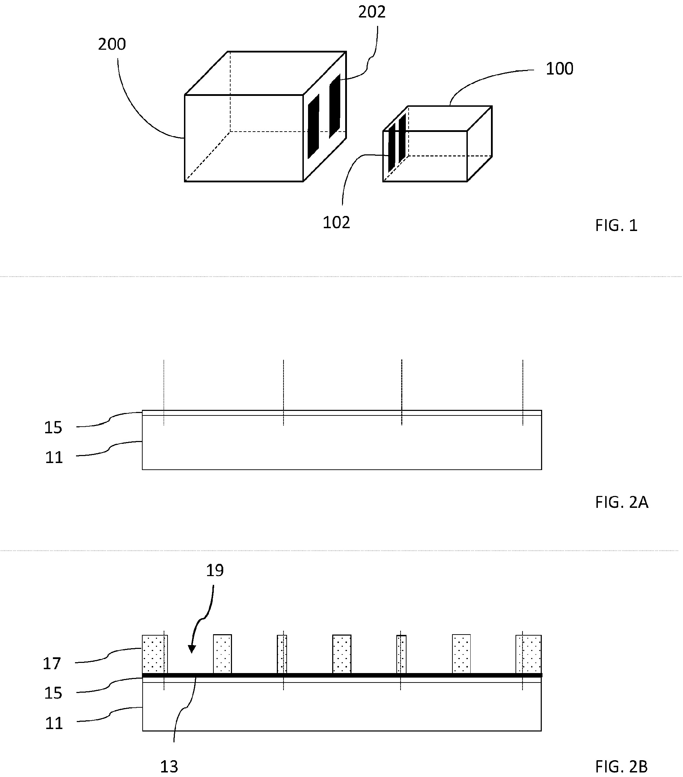

La figure 1 est une vue en perspective illustrant deux composants électroniques à montage en surface 100 et 200, destinés à être assemblés dans des systèmes électroniques plus complexes.

Les composants 100 et 200 sont par exemple des composants de type CSP (de l'anglais « Chip Scale Package » - boîtier à l'échelle de la puce), comportant chacun une puce semiconductrice (non détaillée sur la figure) et, du côté d'au moins une face du composant, dite face de connexion, au moins deux métallisations de contact 102, respectivement 202, connectées à des bornes de connexion (non visibles sur la figure) de la puce semiconductrice. Dans l'exemple de la figure 1, le composant 100 comporte deux métallisations de contact 102 et le composant 200 comporte deux métallisations de contact 202. Chacun des composants 100 et 200 présente par exemple des dimensions latérales (parallèlement à la face de connexion) sensiblement égales aux dimensions latérales de la puce qu'il contient. Dans chacun des composants 100 et 200, la puce semiconductrice du composant est essentiellement constituée par une portion d'un substrat semiconducteur (non détaillé sur la figure), par exemple en silicium, dans et sur lequel sont intégrés des composants semiconducteurs (non détaillés sur la figure). A titre d'exemple, la face arrière du composant 100, respectivement 200, c'est à dire sa face opposée à la face de connexion, est constituée par la face arrière du substrat semiconducteur de la puce qu'il contient, c'est à dire la face du substrat opposée aux composants semiconducteurs. A titre d'exemple, les flancs du composant 100, respectivement 200, sont constitués, au moins en partie, par les flancs du substrat semiconducteur de la puce qu'il contient. A titre d'exemple, une résine de protection entoure latéralement les métallisations de contact 102, respectivement 202, du côté de la face de connexion du composant.

Les composants électroniques 100 et 200 sont, par exemple similaires à l'exception de leurs dimensions, le composant 100 étant plus petit que le composant 200. Les dimensions latérales de la face de connexion du composant 200 sont, par exemple, supérieures à 0,85 mm par 0,5 mm, par exemple de l'ordre de 1 mm par 0,6 mm. Les dimensions latérales de la face de connexion du composant 100 sont, par exemple, inférieures à 0,75 mm par 0,4 mm, par exemple de l'ordre de 0,6 mm par 0,3 mm.

A titre d'exemple, les composants 100 et 200 réalisent la même fonction, par exemple une fonction de protection contre des décharges électrostatiques.

Pour l'assemblage des composants 100, respectivement 200, les métallisations de contact 102, respectivement 202 du composant sont reportées sur des métallisations de contact correspondantes d'un dispositif externe, par exemple une carte de circuit imprimé ou un autre composant électronique.

Du fait de ses dimensions réduites, le composant 100 présente l'avantage d'être moins onéreux que le composant 200, notamment en raison du fait que la puce semiconductrice qu'il contient est plus petite que la puce semiconductrice du composant 200. Ainsi, le composant 100 nécessite pour sa fabrication une portion de substrat semiconducteur de plus petite surface que le composant 200.

Autrement dit, les avancées en matière de miniaturisation permettent de réduire le coût des composants électroniques en réduisant la surface de substrat semiconducteur utilisée pour leur fabrication.

Toutefois, cette miniaturisation peut poser des difficultés d'assemblage dans certaines situations. Par exemple, dans un système électronique dimensionné pour accueillir le composant 200, substituer le composant 100 au composant 200 risque de conduire à un court-circuit ou à un circuit ouvert des métallisations de contact 102 du composant 100 lors de l'assemblage ou risque de conduire à un circuit ouvert, les métallisations de contact 102 du composant 100 n'étant alors pas en contact avec les métallisations de contact correspondantes d'un dispositif externe, par exemple une carte de circuit imprimé ou un autre composant électronique.

Une possibilité pour éviter ce problème serait de redimensionner les métallisations du système électronique destinées à recevoir le composant. Toutefois, ceci implique des développements à l'échelle du système pouvant engendrer un surcoût significatif.

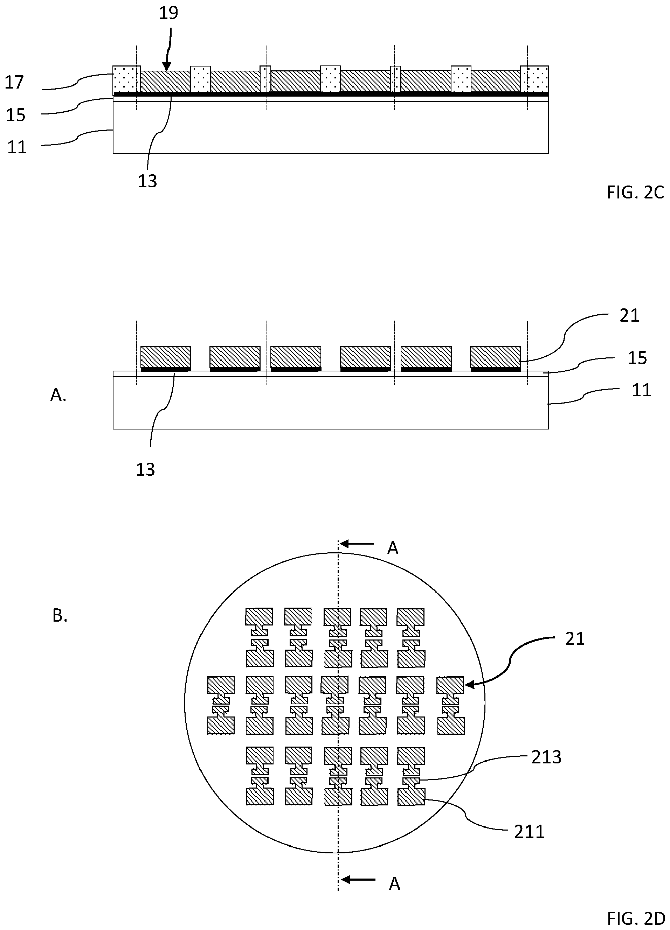

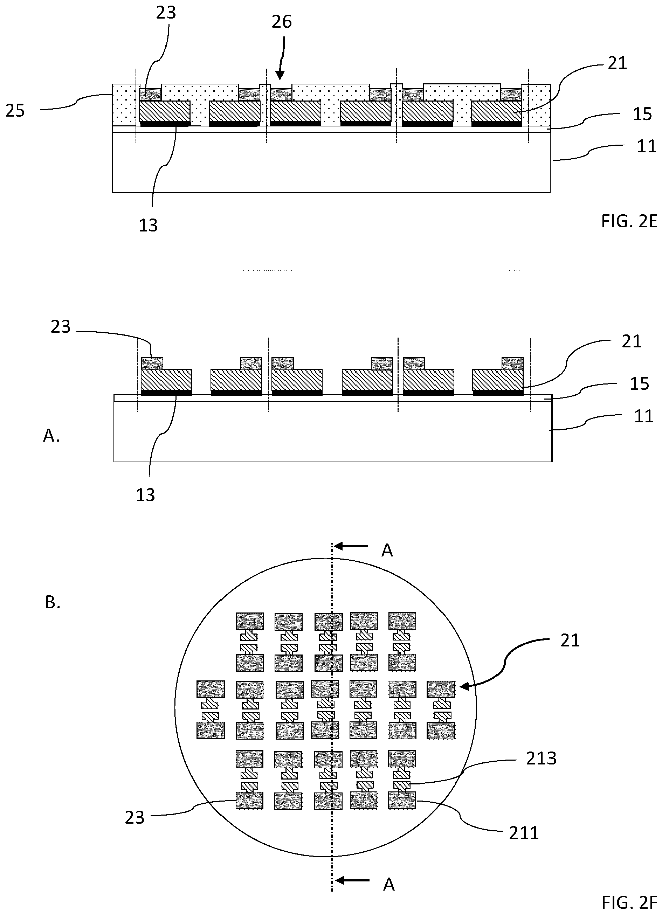

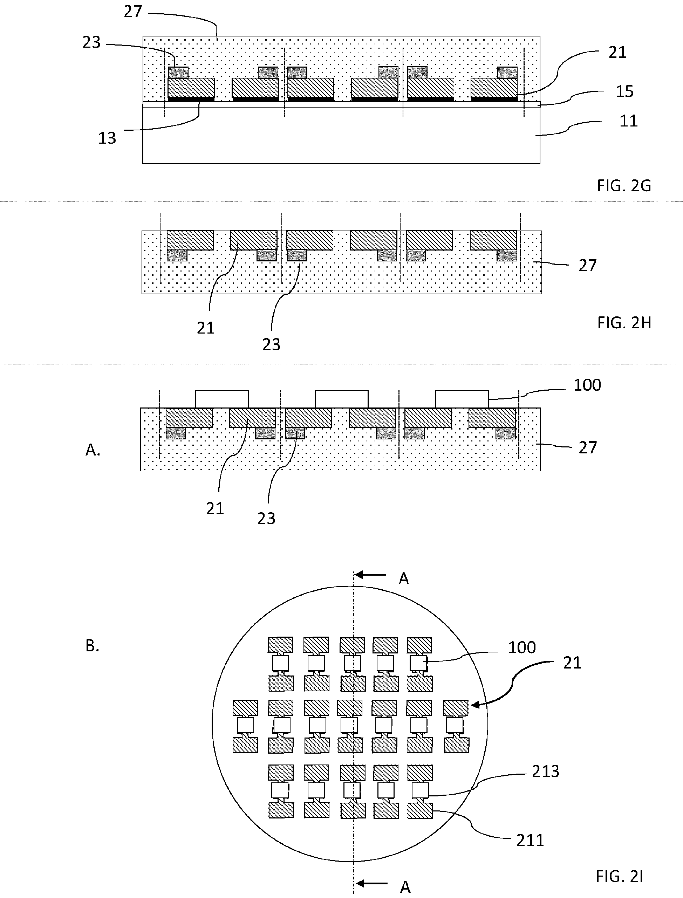

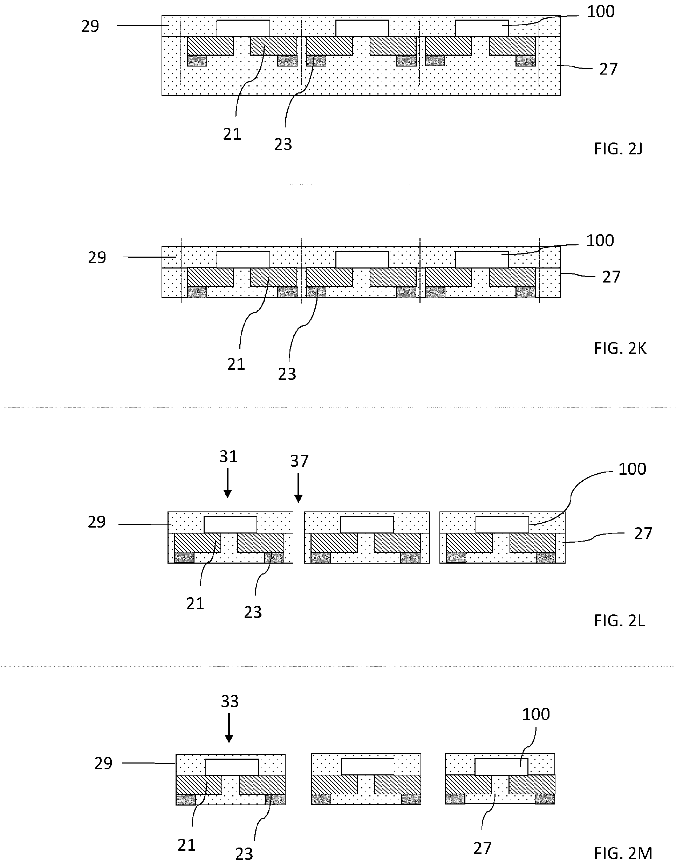

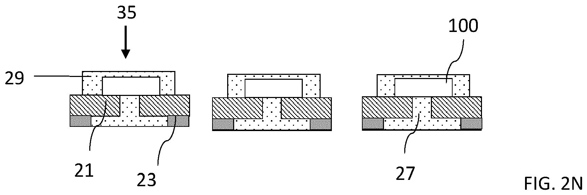

La figure 2A, la figure 2B, la figure 2C, la figure 2D, la figure 2E, la figure 2F, la figure 2G, la figure 2H, la figure 2I, la figure 2J, la figure 2K, la figure 2L, la figure 2M et la figure 2N sont des vues, en coupe et de dessus, partielles et schématiques, d'étapes successives d'un procédé de fabrication d'un composant électronique à montage en surface selon un mode de réalisation.

La figure 2A illustre une structure de départ comportant un substrat 11. Le substrat 11 correspond, par exemple à une plaque d'un matériau semiconducteur, par exemple du silicium. En variante, le substrat 11 correspond à une plaque d'un matériau non semiconducteur, par exemple du verre.

Le substrat 11 a, par exemple une épaisseur comprise entre 150 µm et 900 µm, de préférence comprise entre de 250 µm et 650 µm, par exemple de l'ordre de 500 µm.

Dans l'exemple représenté, la structure de départ comprend une couche de passivation 15, par exemple en oxyde de silicium, revêtant toute la surface supérieure du substrat 11. La couche de passivation 15 est par exemple en contact, par sa face inférieure, avec la face supérieure du substrat 11. A titre de variante, la couche de passivation 15 peut être omise.

On notera que plusieurs composants électroniques sont fabriqués à partir d'une même structure de départ telle qu'illustrée en figure 2A. Dans les structures illustrées ci-après, trois composants électroniques sont formés, délimités par des traits en pointillés. En pratique, le nombre de composants électroniques formés à partir de la structure de départ peut être bien plus important.

Les figures 2B à 2D illustrent des étapes de formation de piliers métalliques 21 du côté de la face supérieure du substrat 11, par exemple sur la face supérieure de la couche de passivation 15.

Plus particulièrement, on vient former, pour chaque composant électronique, un pilier métallique 21 par métallisation de contact 102 du composant 100, soit deux piliers métalliques 21 par composant dans l'exemple représenté.

Les piliers métalliques 21 sont par exemple formés par croissance électrolytique localisée. Pour cela, une couche d'amorce ou d'accroche 13 est d'abord déposée de façon continue et avec une épaisseur sensiblement uniforme sur toute la surface supérieure du substrat 11, par exemple sur et en contact avec la face supérieure de la couche de passivation 15. La couche 13 est par exemple en un matériau métallique, par exemple en cuivre. A titre de variante, la couche 13 est un empilement de plusieurs couches conductrices, par exemple de type UBM (de l'anglais « Under Bump Metallization » - métallisation sous-bossage). La couche d'accroche 13 a, par exemple, une épaisseur inférieure à 5 µm, par exemple inférieure à 3 µm.

En variante, la couche d'accroche 13 peut être localisée à la surface du substrat 11 à l'étape de la figure 2B.

La figure 2B illustre une structure obtenue à l'issue d'une étape de formation d'une première couche en résine 17 sur la face supérieure de la couche d'accroche 13.

A titre d'exemple, lors de cette étape, la couche en résine 17 est formée pleine plaque, c'est-à-dire qu'elle est formée de sorte qu'elle recouvre toute la surface de la face supérieure de la structure illustrée en figure 2A. Le dépôt de la couche en résine 17 est, par exemple, effectuée par centrifugation.

La couche en résine 17 est, par exemple, en une résine photosensible.

A l'issue de l'étape de dépôt de la couche en résine 17, celle-ci subit, par exemple, une photolithographie de sorte qu'elle soit retirée localement en formant des ouvertures 19.

A titre d'exemple, lors de cette étape, une ouverture 19 est formée pour chaque futur pilier 21.

La figure 2C illustre une structure obtenue à l'issue d'une étape de formation de piliers métalliques 21.

Plus particulièrement, lors de cette étape, on vient former les piliers métalliques 21 dans les ouvertures 19. A titre d'exemple, les piliers métalliques 21 sont formés par croissance électrolytique.

Les piliers métalliques 21 sont, par exemple, en cuivre, en or, en étain, en argent ou en un alliage de plusieurs de ces matériaux. A titre d'exemple, la composition des piliers métalliques 21 est homogène, c'est-à-dire qu'elle est la même dans toute la hauteur de chaque pilier métallique 21. A titre d'exemple, les piliers métalliques 21 ne sont pas formés d'une superposition de plusieurs matériaux différents. A titre d'exemple, les piliers 21 ont une hauteur, à l'issue de cette étape, comprise entre 50 µm et 250 µm, par exemple comprise entre 80 µm, et 150 µm, par exemple de l'ordre de 100 µm.

La figure 2D illustre, par une vue A en coupe et une vue B de dessus, une structure obtenue à l'issue d'une étape de retrait de la couche en résine 17, la vue A étant une vue en coupe selon le plan de coupe AA de la vue B.

Plus particulièrement, lors de cette étape, la couche en résine 17 est retirée de façon à dévoiler la face supérieure du substrat 11 et, le cas échéant, la face supérieure de la couche d'accroche 13 et/ou la couche de passivation 15. A titre d'exemple, lors de cette étape, le retrait de la couche en résine 17 est accompagné du retrait des parties de la couche d'accroche 13 non recouvertes par les piliers 21.

A titre de variante, les piliers 21 peuvent être formés localement par sérigraphie sans dépôt préalable de la couche en résine 17.

A titre d'exemple, les piliers métalliques 21 comportent une première partie 211 et une deuxième partie 213. La première partie 211 de chaque pilier métallique 21 est par exemple destinée à être reliée à un dispositif externe, par exemple adapté à recevoir des composants du type du composant 200. La deuxième partie 213 de chaque pilier métallique 21 est par exemple destinée à être connectée à un composant, par exemple du type du composant 100. A titre d'exemple, les parties 213 des piliers métalliques 21 sont similaires par leur forme et leurs dimensions aux métallisations de contact 102 des composants 100. A titre d'exemple, les piliers métalliques 21 sont regroupés au moins deux à deux de sorte que, dans une étape ultérieure, un même composant soit connecté par leurs deuxièmes parties 213 à au moins deux piliers métalliques 21. A titre d'exemple, les piliers 21 sont regroupés de sorte que le nombre de piliers 21 connecté à un même composant soit identique au nombre de métallisations de contact de ce composant, un pilier 21 étant connecté à une métallisation de contact.

Les figures 2E et 2F illustrent des étapes de formation de métallisations de contact 23 du côté de la face supérieure de la structure illustrée en figure 2D.

Plus particulièrement, on vient former, dans cet exemple, en vis-à-vis de chaque pilier 21, une métallisation de contact 23.

La figure 2E illustre une structure obtenue à l'issue d'une étape de formation d'une métallisation de contact 23 par exemple par croissance électrolytique.

Plus particulièrement, lors de cette étape, et similairement à ce qui a été décrit en relation avec les figures 2B et 2C, on vient dans un premier temps déposer une couche en résine 25 sur la face supérieure de la structure illustrée en figure 2D. Suite à son dépôt, la couche en résine 25 subit par exemple une photolithographie de façon à former des ouvertures 26 dans la couche en résine 25. Les ouvertures 26 sont, par exemple, formées en vis-à-vis des piliers métalliques 21 et, plus particulièrement, en vis-à-vis d'une partie seulement des piliers métalliques 21.

Toujours similairement à ce qui a été décrit en relation avec les figures 2B et 2C, lors de cette étape, on vient, dans un second temps, former les métallisations de contact 23 dans les ouvertures 26. A titre d'exemple, les métallisations de contact 23 sont formées en contact avec les piliers métalliques 21. A titre d'exemple, les métallisations de contact 23 sont formées par croissance électrolytique.

Les métallisations de contact 23 sont, par exemple, en cuivre, en or, en étain, en argent ou en un alliage de plusieurs de ces matériaux. A titre d'exemple, la composition des métallisations de contact 23 est homogène, c'est-à-dire qu'elle est la même dans toute la hauteur de chaque métallisation de contact 23. A titre d'exemple, les métallisations de contact 23 ne sont pas formés d'une superposition de plusieurs matériaux différents. A titre d'exemple, les métallisations de contact 23 ont une hauteur, à l'issue de cette étape, comprise entre 20 µm et 150 µm, par exemple comprise entre 20 µm et 100 µm. A titre d'exemple, les métallisations de contact 23 ont une hauteur, à l'issue de cette étape, supérieure ou égale à 30 µm.

La figure 2F illustre, par une vue A en coupe et une vue B de dessus, une structure obtenue à l'issue d'une étape de retrait de la couche en résine 25, la vue A étant une vue en coupe selon le plan de coupe AA de la vue B.

Plus particulièrement, lors de cette étape, la couche en résine 25 est retirée de façon à dévoiler la face supérieure des piliers 21, la face supérieure du substrat 11 et, le cas échéant, la face supérieure de la couche de passivation 15.

A titre d'exemple, comme cela a été représenté sur la vue B de la figure 2F, les métallisations de contact 23 sont formées en vis-à-vis de la première partie 211 des piliers métalliques 21.

A titre d'exemple, les métallisations de contact 23 sont par exemple destinées à être connectées à un circuit imprimé ou un autre composant électronique adapté à recevoir des composants du type du composant 200. A titre d'exemple, les métallisations de contact 23 sont similaires par leur forme et leurs dimensions aux métallisations de contact 202 des composants 200. Les métallisations de contact 23 et les piliers 21, par leurs parties 213, permettent ainsi l'adaptation de composants du type du composant 100 à une utilisation dans des circuits adaptés aux composants du type du composant 200.

A titre de variante, les métallisations de contact 23 peuvent être formées localement par sérigraphie sans dépôt préalable de la couche en résine 25.

La figure 2G illustre une structure obtenue à l'issue d'une étape de formation d'une couche en résine 27 sur la face supérieure de la structure illustrée en figure 2F.

Plus particulièrement, lors de cette étape, on vient par exemple déposer la couche en résine 27 pleine plaque sur la face supérieure de la structure illustrée en figure 2F de sorte qu'elle recouvre entièrement le substrat 11, les piliers 21 et les métallisations de contact 23.

La couche en résine 27 est par exemple déposée par sérigraphie ou moulage.

La couche en résine 27 a, par exemple, une épaisseur permettant de rigidifier la structure pour les étapes ultérieures. A titre d'exemple, la couche en résine 27 a une épaisseur, prise à partir de la face supérieure du substrat 11, comprise entre 100 µm et 700 µm, par exemple comprise entre 300 µm et 600 µm.

A l'issue de cette étape, la structure peut par exemple être stockée en vue de son utilisation ultérieure. On parle ici de structure interposeur ou structure d'adaptation mécanique. Cette capabilité de stockage permet notamment une flexibilité dans la production de composants électroniques, par exemple des composants de protections contre des décharges électrostatiques.

La figure 2H illustre une structure obtenue à l'issue d'une étape de retrait du substrat 11 de la structure illustrée en figure 2G.

On notera que, dans l'exemple des figures 2H à 2N, l'orientation des structures est inversée par rapport aux vues en coupe des figures précédentes, la face supérieure de la structure illustrée en figure 2G correspond alors à la face inférieure de la structure illustrée en figure 2H.

Lors de cette étape, la structure illustrée en figure 2G est par exemple amincie ou polie par sa face inférieure (c'est-à-dire la face supérieure de la structure illustrée en figure 2H), de façon à retirer le substrat 11 et découvrir les piliers 21. A titre d'exemple, la couche de passivation 15, et par exemple la couche d'accroche 13, sont retirées avec le substrat 11 lors de cette étape.

A titre d'exemple, l'étape d'amincissement ou polissage est réalisée par polissage mécano-chimique (CMP, Chemical Mechanical Polishing).

A l'issue de cette étape, la face supérieure de la structure correspond à une face de la couche en résine 27 sur laquelle affleurent les piliers métalliques 21.

La figure 2I illustre, par une vue A en coupe et une vue B de dessus, une structure obtenue à l'issue d'une étape de fixation et connexion électrique de composants 100 sur la face supérieure de la structure illustrée en figure 2H, la vue A étant une vue en coupe selon le plan de coupe AA de la vue B.

Lors de cette étape, les composants 100 sont fixées à la surface de la face supérieure de la structure illustrée en figure 2H de sorte que, par exemple, deux piliers métalliques 21 voisins soient reliés par un unique composant 100. A titre d'exemple, les composants 100 sont connectés aux piliers 21 par leurs deuxièmes parties 213. A titre d'exemple, les composants 100 sont fixés sur les piliers 21 à l'aide d'une pâte à braser. A titre d'exemple, après le report des composants 100, la structure subit un recuit.

Les composants 100 sont, par exemple, reportés individuellement, par exemple par une technique de prélèvement et placement ("pick and place" en langue anglaise).

La figure 2J illustre une structure obtenue à l'issue d'une étape de dépôt d'une couche en résine 29 sur la face supérieure de la structure illustrée en figure 2I.

Plus particulièrement, lors de cette étape, on vient par exemple déposer la couche en résine 29 pleine plaque sur la face supérieure de la structure illustrée en figure 2I de sorte qu'elle recouvre entièrement les composants 100 et la face supérieure des piliers 21.

A l'issue de cette étape, les composants 100, liés aux piliers 21 et aux métallisations de contact 23 sont comme encapsulés ou moulés dans les couches en résine 27 et 29.

A titre d'exemple, la couche en résine 27 et la couche en résine 29 sont en le même matériau. En variante, les couches en résine 27 et 29 sont en des matériaux différents.

La couche en résine 29 est, par exemple, formée avec une épaisseur, prise à partir de la face supérieure du composant 100, comprise entre 10 µm et 100 µm, par exemple comprise entre 10 µm et 50 µm, par exemple comprise entre 15 µm et 25 µm. A titre d'exemple, l'épaisseur de la couche en résine 29 est fonction de la taille souhaitée du composant électronique final.

La figure 2K illustre une structure obtenue à l'issue d'une étape d'amincissement de la structure illustrée en figure 2J.

Lors de cette étape, la structure illustrée en figure 2J est par exemple amincie ou polie par sa partie inférieure, de façon à retirer une partie inférieure de la couche en résine 27 et découvrir les métallisations de contact 23.

A titre d'exemple, lors de cette étape, l'amincissement de la structure est stoppé lorsque la face inférieure des métallisations de contact 23 est découverte.

A titre d'exemple, l'étape d'amincissement ou polissage est réalisée par polissage mécano-chimique (CMP, de l'anglais « Chemical Mechanical Polishing »).

Les figures 2L à 2N illustrent des structures obtenues à l'issue d'étapes différentes de découpe de la structure illustrée en figure 2K de façon à former une pluralité de composants électroniques à montage en surface 31, 33 ou 35, chaque composant 31, 33 ou 35 comportant un composant 100.

Plus particulièrement, la figure 2L illustre une structure obtenue à l'issue d'une étape de découpe de la structure illustrée en figure 2K, selon un premier mode de réalisation, de façon à former une pluralité de composants électroniques à montage en surface 31.

Préalablement à cette étape, la structure est par exemple rapportée, par sa face arrière, sur un film support, non représenté en figure 2L.

Lors de cette étape, on vient former dans la structure des ouvertures 37 traversantes dans les couches en résine 29 et 27. A titre d'exemple, une ouverture 37 est réalisée entre chaque assemblage d'un composant 100, d'au moins deux piliers 21 et d'au moins deux métallisations de contact 23.

Les ouvertures 37 peuvent, par exemple, être réalisées par sciage. Les ouvertures 37 peuvent, en variante, être réalisées par ablation laser.

En figure 2L, les ouvertures 37 sont réalisées de sorte qu'elles ne découvrent pas les flancs des piliers 21 adjacents. Les composants électroniques à montage en surface ont donc leurs flancs entièrement recouverts par les couches en résine 27 et 29 à l'exception du flanc inférieur au niveau duquel affleurent les métallisations de contact 23.

A l'issue de cette étape, la structure obtenue correspond à une pluralité de composants électroniques à montage en surface 31, reliées uniquement par le film support (non représenté en figure 2L). Les composants électroniques à montage en surface 31 peuvent ensuite être prélevés sur ce film support, en vue de leur montage dans un dispositif extérieur.

Similairement, la figure 2M illustre une structure obtenue à l'issue d'une étape de découpe de la structure illustrée en figure 2K, selon un deuxième mode de réalisation, de façon à former une pluralité de composants électroniques à montage en surface 33.

Cette étape de découpe est, par exemple similaire à l'étape de découpe illustrée en figure 2L à la différence que la largeur de l'ouverture 37 formée est supérieure à celle décrite en relation avec la figure 2L.

A titre d'exemple, lors de cette étape, l'ouverture 37 est réalisée de sorte qu'elle découvre les flancs des piliers 21 et des métallisations de contact 23. L'ouverture 37 a donc une largeur supérieure ou égale à la distance entre deux piliers de deux composants 33 voisins.

Les composants à montage en surface 33 ont, à l'issue de cette étape, leurs flancs entièrement recouverts par les couches en résine 27 et 29 à l'exception de leur face inférieure au niveau duquel affleurent les métallisations de contact 23 et de deux des flancs latéraux au niveau desquels les métallisations de contacts 23 et les piliers 21 affleurent. Les composants 33 à montage en surface ont alors une structure dont deux de leurs flancs sont mouillables.

Encore similairement, la figure 2N illustre une structure obtenue à l'issue d'une étape de découpe de la structure illustrée en figure 2K, selon un troisième mode de réalisation, de façon à former une pluralité de composants électroniques à montage en surface 35.

Cette étape de découpe est, par exemple similaire à l'étape de découpe illustrée en figure 2M à la différence près qu'elle comprend une étape de découpe partielle supplémentaire.

A titre d'exemple, lors de cette étape, en plus de l'ouverture 37, on vient réaliser une autre ouverture 39 non traversante en vis-à-vis de chaque ouverture 37. Les ouvertures 39 sont, par exemple, réalisées à partir de la face supérieure de la structure illustrée en figure 2K. Les ouvertures 39 débouchent par exemple sur la face supérieure des piliers 21.

A titre d'exemple, les ouvertures 39 ont une largeur supérieure à la largeur des ouvertures 37. Les ouvertures 39 peuvent être réalisées par sciage. Les ouvertures 39 peuvent, en variante, être réalisées par ablation laser.

Les composants à montage en surface 35 ont, à l'issue de cette étape, leurs flancs entièrement recouverts par les couches en résine 27 et 29 à l'exception de leur face inférieure au niveau duquel affleurent les métallisations de contact 23 et de deux des flancs latéraux présentant une marche au niveau de laquelle les métallisations de contacts 23 et les piliers 21 affleurent. Les composants à montage en surface 35 ont alors une structure dont trois de leurs flancs sont mouillables.

Un avantage du présent mode de réalisation est qu'il permet de déporter les métallisations de contact des composants de façon à adapter un composant du type du composant 100 pour une utilisation dans un circuit destiné à des composant du type du composant 200.

Un autre avantage du présent mode de réalisation est qu'il permet de produire des composants électriques aux dimensions finales souhaitées en adaptant l'épaisseur de la couche en résine 29, des piliers métalliques 21 et des métallisations de contact 23.

Encore un autre avantage est qu'il permet de produire des composants à moindre coût.

Encore un autre avantage est qu'il permet de stocker l'interposeur illustré en figure 2H, pour une utilisation ultérieure, par un composant nécessitant l'adaptation d'empreinte sur le circuit imprimé défini par l'interposeur.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisations décrits ne se limitent pas aux exemples de dimensions et de matériaux mentionnées ci-dessus.

Enfin, la mise en oeuvre pratique des modes de réalisation et variantes décrits est à la portée de la personne du métier à partir des indications fonctionnelles données ci-dessus.

## Revendications

1. Procédé de fabrication d'une pluralité de premiers composants électroniques (31 ; 33 ; 35) comportant chacun un deuxième composant électronique (100), chaque deuxième composant électronique (100) comportant au moins deux métallisations de contact (102) du côté d'une face de connexion du deuxième composant électronique (100), le procédé comportant les étapes successives suivantes :
a) former, sur une face d'un substrat (11), pour chaque deuxième composant électronique (100), au moins deux piliers métalliques (21) destinés à être connectés respectivement auxdites au moins deux métallisations de contact (102) du deuxième composant électronique (100), lesdits piliers métalliques (21) présentant chacun une surface supérieure à la surface de la métallisation de contact (102) correspondante du deuxième composant électronique (100) ;
b) former, sur une partie seulement de la surface de chaque pilier métallique (21), une métallisation de contact (23) du composant électronique (31 ; 33 ; 35) ;
c) recouvrir ladite face du substrat (11), les piliers métallique (21) et les métallisations de contact (23) des premiers composants électroniques (31 ; 33 ; 35) par une première couche en résine (27) ;
d) retirer le substrat (11) de façon à dévoiler une face des piliers métalliques (21), opposée aux métallisations de contact (23) des composants électroniques (31 ; 33; 35) ;
e) fixer et connecter électriquement les deuxièmes composants électroniques (100), par leurs métallisations de contact (102), sur la face des piliers métalliques (21) opposée aux métallisations de contact (23) des premiers composants électroniques (31 ; 33 ; 35) ;
f) amincir la première couche en résine (27) de façon à dévoiler la face des métallisations de contact (23) des premiers composants électroniques (31 ; 33 ; 35) opposée aux piliers métalliques (21) ; et
g) découper la première couche en résine (27) de façon à individualiser les premiers composants électroniques (31 ; 33 ; 35) .

2. Procédé selon la revendication 1, dans lequel les piliers métalliques (21) sont formés par croissance électrolytique.

3. Procédé selon la revendication 1 ou 2, dans lequel les métallisations de contact (23) des premiers composants électroniques (31 ; 33 ; 35) sont formées par croissance électrolytique.

4. Procédé selon l'une quelconque des revendications 1 à 3, comportant après l'étape e) une étape de recouvrement des deuxièmes composants électroniques (100), et des métallisations de contact (23) des premiers composants électroniques (31 ; 33 ; 35) par une deuxième couche en résine (29).

5. Procédé selon l'une quelconque des revendications 1 à 4, dans lequel lors de la découpe de l'étape g), les flancs des piliers métalliques (21) et des métallisations de contact (23) des premiers composants électroniques (31 ; 33 ; 35) sont dévoilés.

6. Procédé selon l'une quelconque des revendications 1 à 5, dans lequel les piliers métalliques (21) sont en cuivre, en or, en étain, en argent ou en un alliage de plusieurs de ces matériaux.

7. Procédé selon l'une quelconque des revendications 1 à 6, dans lequel les métallisations de contact (23) des premiers composants électroniques (31 ; 33 ; 35) sont en cuivre, en or, en étain, en argent ou en un alliage de plusieurs de ces matériaux.

8. Procédé selon l'une quelconque des revendications 1 à 7, dans lequel les métallisations de contact (23) des premiers composants électroniques (31 ; 33 ; 35) ont une hauteur comprise entre 20 µm et 100 µm.

9. Procédé selon la revendication 8, dans lequel les métallisations de contact (23) des premiers composants électroniques (31 ; 33 ; 35) ont une hauteur supérieure ou égale à 30 µm.

10. Procédé selon l'une quelconque des revendications 1 à 9, dans lequel les piliers métalliques (21) ont une hauteur comprise entre 80 µm et 150 µm.

11. Procédé selon l'une quelconque des revendications 1 à 10, dans lequel, lors de l'étape g), la découpe de la première couche en résine (27) est réalisée de sorte que la première couche en résine (27) subsiste sur des flancs du composant électronique (31 ; 33 ; 35).

12. Procédé selon l'une quelconque des revendications 1 à 10, dans lequel, lors de l'étape g), la découpe de la première couche en résine (27) est réalisée de sorte que, à l'issue de cette étape, les métallisations de contact (23) des premiers composants électroniques (31 ; 33 ; 35) et les piliers métalliques (21) affleurent des flancs du composant électronique (31 ; 33 ; 35).

13. Procédé selon l'une quelconque des revendications 1 à 10, dans lequel, lors de l'étape g), un premier trait de découpe traversant est réalisé de sorte que les métallisations de contact (23) des premiers composants électroniques (31 ; 33 ; 35) et les piliers métalliques (21) affleurent des flancs du composant électronique (31 ; 33 ; 35) et un deuxième trait de découpe non traversant, dont la largeur de découpe est supérieure à la largeur de découpe du premier trait de découpe, est réalisé de façon à découvrir une partie de la face des piliers métalliques (21) opposée aux métallisations de contact (23) des premiers composants électroniques (31 ; 33 ; 35).

14. Procédé selon l'une quelconque des revendications 1 à 13, dans lequel, après l'étape e), la structure est stockée pour être utilisée ultérieurement.
